# EUROPEAN PATENT APPLICATION

(11) **EP 4 331 732 A1**
(43) Date of publication of application: **06.03.2024**
(21) Application number: 22795529.1
(22) Date of filing: 31.03.2022
(51) Int. Cl.: B05C 5/00, H01L 21/027, H01L 21/677

(54) **CONTAINER**

(30) Priority: 28.04.2021 JP 2021076528
(71) Applicant: Tokyo Electron Limited, Tokyo 107-6325 (JP); Aicello Corporation, Toyohashi-shi, Aichi 441-1115 (JP)
(72) Inventor: TSUCHIYA Katsuhiro, Tokyo 107-6325 (JP); HIRAO Takeshi, Koshi City, Kumamoto 8611116 (JP); INADA Hiroichi, Koshi City, Kumamoto 8611116 (JP); KUTSUNA Yoshimichi, Toyohashi-shi, Aichi 441-1115 (JP); YAMAMOTO Takashi, Toyohashi-shi, Aichi 441-1115 (JP)
(74) Representative: Hoffmann Eitle
(86) International application number: PCT/JP2022/016775
(87) International publication number: WO 2022/230613

(57) **Abstract**

A technique capable of reducing, when processing a substrate by using a processing liquid, a burden in the processing and a burden in works involved in the processing is provided. A container includes a storage space forming unit 20 in which a storage space 59 storing therein a processing liquid configured to process a substrate is formed; a discharge port 25 of the processing liquid, provided in the storage space forming unit; and a fragile member 47 provided in the storage space forming unit and configured to be broken by being pressurized with a penetrating member in order to form an access path, the penetrating member being configured to pressurize the storage space such that the processing liquid is discharged from the discharge port, and the penetrating member being advanced into the storage space forming unit through the access path.

## Description

### TECHNICAL FIELD

The various aspects and embodiments described herein pertain generally to a container.

### BACKGROUND

In a manufacturing process for a semiconductor device, various processing liquids are supplied to a semiconductor wafer (hereinafter, simply referred to as a wafer) as a substrate by a substrate processing apparatus. Patent Document 1 describes a substrate processing apparatus (coating apparatus) that supplies resist (a photoresist liquid) as a processing liquid to a substrate to form a resist film by spin coating. This coating apparatus is equipped with a storage tank storing the resist therein; a supply nozzle; and a supply pipe connecting the storage tank and the supply nozzle and provided with a bellows pump.

### PRIOR ART DOCUMENT

Patent Document 1: Japanese Patent Laid-open Publication No. H11-354419

### DISCLOSURE OF THE INVENTION

### PROBLEMS TO BE SOLVED BY THE INVENTION

Exemplary embodiments provide a technique capable of reducing, when processing a substrate by using a processing liquid, a burden in the processing and a burden in works involved in the processing.

### MEANS FOR SOLVING THE PROBLEMS

In an exemplary embodiment, a container includes a storage space forming unit in which a storage space storing therein a processing liquid configured to process a substrate is formed; a discharge port of the processing liquid, provided in the storage space forming unit; and a fragile member provided in the storage space forming unit and configured to be broken by being pressurized with a penetrating member in order to form an access path, the penetrating member being configured to pressurize the storage space such that the processing liquid is discharged from the discharge port, and the penetrating member being advanced into the storage space forming unit through the access path.

### EFFECT OF THE INVENTION

According to the exemplary embodiment, when processing the substrate by using the processing liquid, it is possible to reduce the burden in the processing and the burden in works involved in the processing.

### BRIEF DESCRIPTION OF THE DRAWINGS

**FIG. 1** is a plan view of a resist coating apparatus equipped with a container according to an exemplary embodiment.
**FIG. 2** is a schematic side view of the resist coating apparatus.
**FIG. 3** is a perspective view of the container and a transfer unit provided in the resist coating apparatus.
**FIG. 4** is a perspective view of the container.
**FIG. 5** is a longitudinal side view of the container.
**FIG. 6** is a plan view of an upper cover constituting the container.
**FIG. 7** is a plan view of an inner cover constituting the container.
**FIG. 8** is a longitudinal side view of the container and the transfer unit.
**FIG. 9** is a longitudinal side view of the container and the transfer unit.

### DETAILED DESCRIPTION

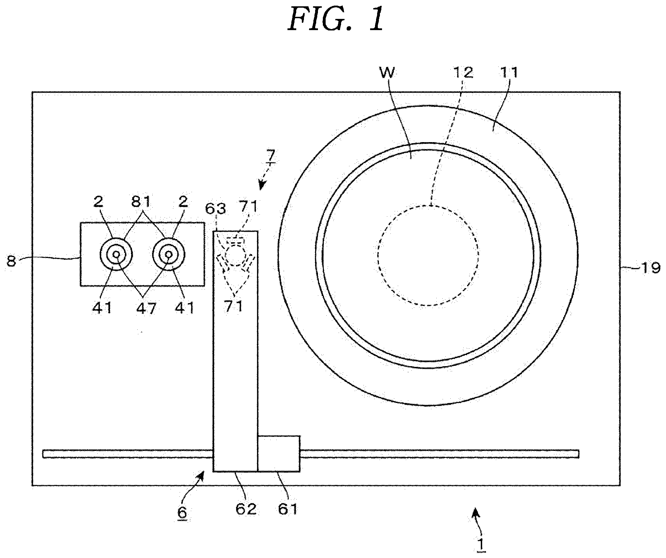

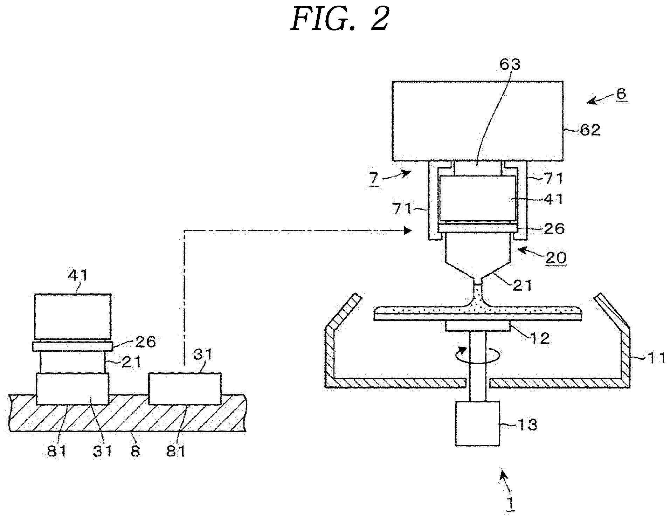

A resist coating apparatus 1 including a container according to an exemplary embodiment of the present disclosure will be described with reference to a plan view of FIG. 1 and a schematic side view of **FIG. 2****.** First, an outline of the configuration of the resist coating apparatus 1 will be described. The resist coating apparatus 1 is configured to supply resist as a processing liquid to a wafer W, which is a circular substrate, and forms a resist film by spin coating. This resist coating apparatus 1 is equipped with a cup 11, a container 2, a transfer unit 6, a container placement unit 8, and a base 19. A plurality of, for example, two containers 2 are disposed in the container placement unit 8, and different types of resist are stored in these containers 2, for example. A container nozzle 20 constituting the container 2 is used not only as a nozzle but also as a tank configured to store the resist therein.

The transfer unit 6 is configured to mount and grip the container nozzle 20 of selected one of the containers 2 and transfer it from the container placement unit 8 to a processing position above the wafer W within the cup 11, and then, is configured to discharge the resist onto the wafer W from the container nozzle 20. The container nozzle 20 before being mounted to the transfer unit 6 is configured to have a hermetically sealed inside. When mounted to the transfer unit 6, a fragile member 47 forming a wall portion of the container nozzle 20 is broken and deformed by being pressurized by a supply/exhaust pipe 68 that constitutes the transfer unit 6. The supply/exhaust pipe 68 is put into the container nozzle 20 through an access path 47A formed as a result of the breaking and deformation of the fragile member 47. By supplying a gas and exhausting the gas from the supply/exhaust pipe 68, the container nozzle 20 can be pressurized and decompressed, and the discharge and the stop of the discharge of the resist are switched. The container nozzle 20 after being used is released from the transfer unit 6, and is then returned back to the container placement unit 8.

Hereinafter, the configuration of the resist coating apparatus 1 will be described in more detail. The cup 11 and the container placement unit 8 are disposed on the right side and the left side of the base 19, respectively. A spin chuck 12 is provided in the cup 11. The spin chuck 12 is configured to attract a central portion of a rear surface of the wafer W and hold the wafer W horizontally. The spin chuck 12 is connected to a rotation mechanism 13, and the wafer W is rotated around a vertical axis along with the spin chuck 12 by the rotation mechanism 13. The wafer W is transferred to above the cup 11 from a transfer area behind the cup 11 by a non-illustrated transfer mechanism. Then, the wafer W is handed over between the transfer mechanism above the cup 11 and the spin chuck 12 by a non-illustrated elevating pin provided in the cup 11.

In the container placement unit 8, the containers 2 are arranged in a layout that allows the container nozzle 20 to be mounted to and gripped by the transfer unit 6, which will be described in detail later. In the present exemplary embodiment, the container placement unit 8 is provided with two recessed portions 81 arranged in a left-and-right direction, and the containers 2 are respectively disposed in these recessed portions 81. To be more specific, a lower cover 31 constituting the container 2 is fixed to the recessed portion 81, and attachment/detachment of this lower cover 31 to/from the container nozzle 20 is enabled by an elevating operation of the transfer unit 6 gripping the container nozzle 20. This attachment/detachment of the lower cover 31 will be described in detail later.

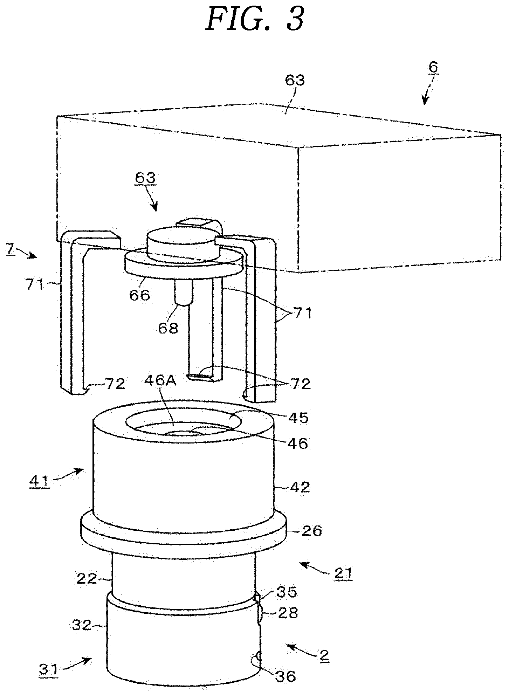

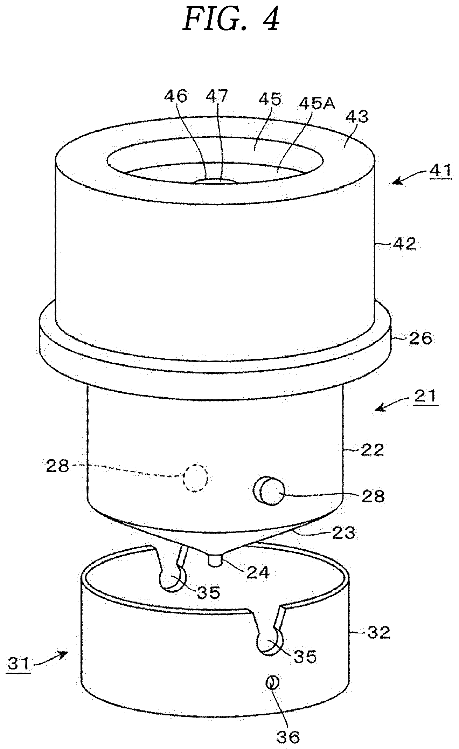

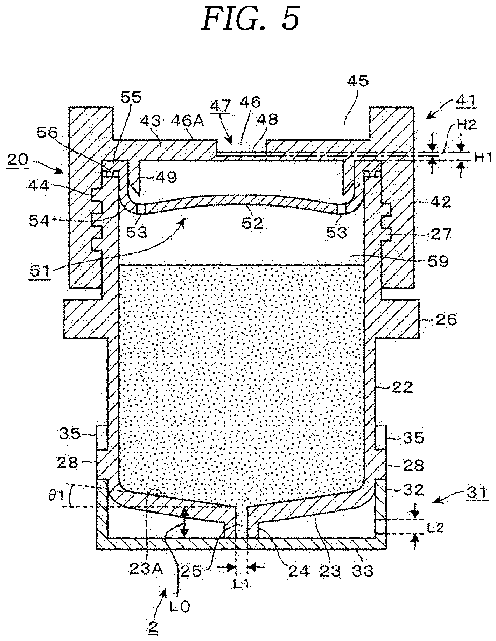

Hereinafter, the container 2 will be elaborated with reference to perspective views of **FIG. 3** and **FIG. 4** and a longitudinal side view of **FIG. 5****.** The container 2 has a vertically elongated cylindrical shape, and is composed of a container main body 21, the lower cover 31, an upper cover 41, and an inner cover 51. The container nozzle 20 is composed of the container main body 21, the upper cover 41, and the inner cover 51, and its outer surface is formed by the container main body 21 and the upper cover 41. That is, the inner cover 51 is provided in a space formed by the container main body 21 and the upper cover 41. Further, the container nozzle 20 is a storage space forming unit having a storage space 59 therein. Each of the lower cover 31, the upper cover 41, and the inner cover 51 is attachable to and detachable from the container main body 21. **FIG. 3** illustrates a state in which the lower cover 31 is attached, and **FIG. 4** illustrates a state in which the lower cover 31 is separated. The lower cover 31 is fixed to the container placement unit 8, and the lower cover 31 is detached when the container nozzle 20 is transferred by the transfer unit 6 as described above.

The container main body 21, the lower cover 31, the upper cover 41, and the inner cover 51 that constitute the container 2 are circular members whose central axes are coincident when viewed from the top. The container main body 21, the lower cover 31, and the upper cover 41 are made of, for example, an integrally molded resin. Specifically, they are made of a thermoplastic resin, desirably, polyolefin, and, more desirably, polyethylene or polypropylene.

Hereinafter, each member constituting the container 2 will be explained. When the container 2 is used, the central axis of each member lies vertical. In the following description, the central axis will be assumed to be vertical in this way. The container main body 21 will be first described. The container main body 21 includes a cylindrical member 22 forming a body thereof, and this cylindrical member 22 forms the storage space 59 for resist. A portion of the container main body 21 under the cylindrical member 22 is formed in a funnel shape. To elaborate, a lower peripheral wall of the cylindrical member 22 is elongated toward the central axis of the container main body 21 as it goes downwards, forming an inclined wall 23. A lower end of this inclined wall 23 is slightly extended vertically downwards to form a leading end portion 24. An area surrounded by this leading end portion 24 is configured as a discharge port 25 opened downwards, and the center of this discharge port 25 lies on the central axis of the container main body 21.

Since the bottom of the container main body 21 is formed by the inclined wall 23 as described above, the resist in the container main body 21 flows down toward the discharge port 25 along an inner peripheral surface 23A of the inclined wall 23 when using up the resist in the storage space 59, so that the liquid is suppressed from remaining in the container main body 21. The angle formed by the inner peripheral surface 23A of the inclined wall 23 and a horizontal plane is set to θ1. If the angle θ1 is too small, it becomes difficult for the resist to flow down, whereas if the angle θ1 is too large, the height of the bottom of the container main body 21 increases. Therefore, the angle θ1 is desirably set to be in the range of 1° to 60°, and, more desirably, in the range of 1° to 45°. In addition, if a hole diameter L1 of the discharge port 25 is too large, the resist may leak out, whereas if the hole diameter L1 is too small, it may be difficult to fill the inside of the leading end portion 24 with the resist by the pressure of the storage space 59. On this ground, it is desirable to set the hole diameter L1 to 0.5 mm to 2.0 mm. Further, in **FIG. 5****,** L0 denotes the length of the discharge port 25. If this length L0 is too large, it becomes difficult for the resist to flow down. If the length L0 is too small, on the other hand, the resist may flow too easily. Thus, it is desirable to set the length L0 to, *e.g.,* 4 mm or more. In addition, it is desirable to design the hole diameter L1 and the length L0 of the discharge port 25 to have optimal sizes in consideration of the size of the container 2, the viscosity of the resist, *etc.*

A central portion of an outer peripheral surface of the cylindrical member 22 in a height direction is protruded toward the outside of the cylindrical member 22, thereby forming an annular handle 26. Accordingly, this handle 26 is a protruding portion that is projected toward the outside of the container main body 21 on the lateral side of the container main body 21 along the circumferential direction of the container main body 21. Furter, the upper cover 41 is provided above the handle 26. As described above, since the individual members constituting the container 2 are integrally molded, the handle 26 is formed integrally with the cylindrical member 22, and, therefore, cannot be detached from the cylindrical member 22. As will be described later, the transfer unit 6 grips the handle 26.

On the outer peripheral surface of the cylindrical member 22 above the handle 26, a spiral protrusion is formed along the outer peripheral surface of the cylindrical member 22 with the central axis of the cylindrical member 22 as a spiral axis, forming a male screw 27. Further, two protrusions 28 protruding in the horizontal direction are formed on the outer peripheral surface of the cylindrical member 22 below the handle 26. These protrusions 28 are formed as portions of the outer peripheral surface of the cylindrical member 22, which are spaced apart from each other at an angular interval of 180° with respect to the central axis of the cylindrical member 22 and have the same height, are protruded in opposite directions. Each protrusion 28 has a circular shape, when viewed from the protruding direction.

Now, the lower cover 31 will be described. The lower cover 31 is composed of a vertically standing cylindrical member 32 and a bottom plate 33 that closes a lower portion of the cylindrical member 32. The cylindrical member 32 surrounds a lower portion of the container main body 21. Two portions on an upper end of the cylindrical member 32, which are spaced apart from each other in the circumferential direction, are formed as grooves 35 by being notched downwards. These grooves 35 are formed at positions 180° apart from each other with respect to the central axis of the cylindrical member 32, and are formed so as to receive the protrusions 28 of the above-described cylindrical member 22 inserted thereinto. The groove 35 is formed in a keyhole shape. Specifically, a width of an upper portion of the groove 35 becomes slightly narrower as it goes downwards, and a width at a lower end thereof is slightly smaller than the diameter of the circle when the protrusions 28 is viewed from the protruding direction. A lower portion of the groove 35 is formed in a circular shape, and its size is approximately equal to the size of the circle when the protrusion 28 is viewed from the protruding direction. Therefore, it can be said that a constriction portion that narrows the width of the groove 35 is provided on the way the groove 35 goes downwards.

The mount of the lower cover 31 to the container main body 21 will be described. In the state that the lower cover 31 and the container main body 21 are separated from each other, their central axes are aligned, and the positions of the protrusions 28 are adjusted to be overlapped with the grooves 35 when viewed from the axial direction. Then, the container main body 21 is moved relative to the lower cover 31 along the axial direction to come closer to the lower cover 31, thus allowing the protrusions 28 to be put into the grooves 35. By pressing the container main body 21 toward the lower cover 31 in this state, the protrusion 28 is moved to the inside of the groove 35 beyond the constriction portion of the groove 35, and the protrusion 28 and the groove 35 are engaged with each other (joined together). In this way, the protrusion 28 and the groove 35 are configured as an engaging member and an engaged member, respectively, and they form an engagement between the container main body 21 and the lower cover 31 to fix their relative positions.

In the state that the engagement is formed and the container main body 21 and the lower cover 31 are fixed to each other in this way, the leading end portion 24 of the container main body 21 is in contact with the bottom plate 33 of the lower cover 31, so the discharge port 25 is blocked, and the resist in the container main body 21 does not leak from the discharge port 25. Further, since the lower portion of the container main body 21 has a pointed shape due to the presence of the inclined wall 23, the lower cover 31 also has, in addition to the above-described function of blocking the discharge port 25, a function of suppressing, when mounted to the container main body 21, the container main body 21 from being tilted, thus enabling the container main body 21 to maintain a proper posture.

Further, by applying a force along the axial direction to move the container main body 21 relatively away from the lower cover 31, the protrusion 28 is moved beyond the constriction portion to an inlet of the groove 35, and the engagement is released. As a result, the lower cover 31 is separated from the container main body 21. As will be described later, the lower cover 31 is fixed to the container placement unit 8, and in that state, the transfer unit 6 holding the container nozzle 20 including the container main body 21 is moved up and down with respect to the lower cover 31. As a result, such engagement and release of the engagement are performed.

The configuration of the lower cover 31 will be further elaborated. A through hole 36 is formed at the cylindrical member 32 of the lower cover 31 to be positioned under one of the grooves 35, and this through hole 36 is opened to a space surrounded by the inclined wall 23 of the container main body 21 and the lower cover 31 when the lower cover 31 is mounted. This through hole 36 serves to suppress the space surrounded by the inclined wall 23 and the lower cover 31 from being turned into a negative pressure when the lower cover 31 is separated from the container main body 21. By suppressing the negative pressure in this way, a leak of the resist from the discharge port 25 of the container main body 21 into the lower cover 31 is suppressed. In this way, since the through hole 36 suppresses a pressure fluctuation in the space surrounded by the container main body 21 and the lower cover 31 by enabling communication with an atmosphere (exterior air) outside the container 2, the through hole 36 may also be referred to as a ventilation hole that enables the inside of the lower cover 31 to communicate with the exterior air. This through hole 36 has a diameter L2 ranging from, *e.g*., 0.5 mm to 2 mm, more specifically, 1 mm, for example.

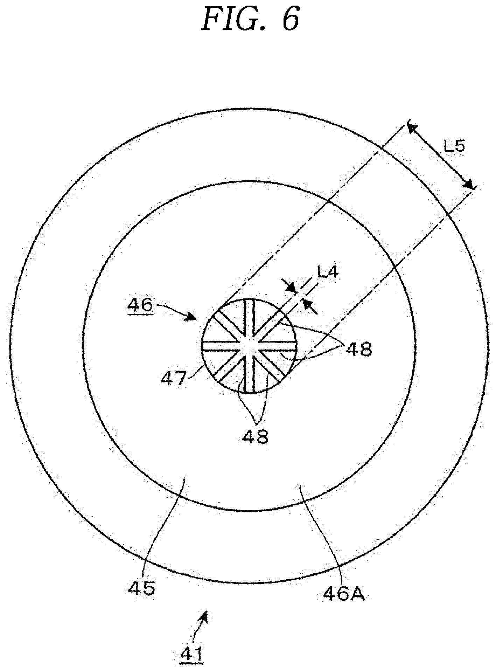

Next, the upper cover 41 will be described with reference to FIG. 6, which is a plan view. The upper cover 41 includes a vertically standing cylindrical member 42, and an upper wall 43 configured to close an upper side of the cylindrical member 42. On an inner peripheral surface of the cylindrical member 42, a spiral groove is formed along the inner peripheral surface of the cylindrical member 42 with a central axis of the cylindrical member 42 as a spiral axis, forming a female screw 44. By screwing the male screw 27 of the container main body 21 into the female screw 44, the upper cover 41 is mounted and fixed to the container main body 21. A circular recessed portion 45 is provided on a top surface of the upper wall 43. A circular recessed portion 46 is provided at a center portion of the recessed portion 45. The centers of the recessed portions 45 and 46 are located on the central axis of the upper cover 41. A bottom of the recessed portion 46 is the aforementioned fragile member 47 and is formed in a horizontal thin plate shape. The above-described supply/exhaust pipe 68 is vertically elongated, and as the lower end of the supply/exhaust pipe 68 presses the fragile member 47 vertically downwards to pierce it, the fragile member 47 is broken.

For example, two to six linear grooves 48 are provided on a top surface of the fragile member 47 so as to intersect each other at the center of the fragile member 47 when viewed from the top. Accordingly, the plurality of grooves are formed so as to extend radially from the center of the fragile member 47. From another perspective, the plurality of grooves are connected to each other at the center of the fragile member 47. Additionally, the grooves 48 are formed locally on the top surface of the fragile member 47, that is, they are not formed on the entire top surface of the fragile member 47. In the present exemplary embodiment, four grooves 48 are formed and arranged at an angular interval of 45° with respect to the center of the fragile member 47 so as to intersect each other at the center of the fragile member 47. Accordingly, the grooves 48 divide the top surface of the fragile member 47 into eight equal parts to form eight fan-shaped areas of the same shape.

The portion of the fragile member 47 where each groove 48 is formed is configured as a thin wall member whose thickness is smaller than that of a portion outside the thin wall member. When the fragile member 47 is pressed by the supply/exhaust pipe 68, the fragile member 47 is broken along the groove 48. In addition, since the plurality of grooves are connected at the center of the fragile member 47 as described above, cracks begin to occur from the center of the fragile member 47 and develop toward a periphery thereof. Eight fan-shaped small pieces formed by such fracture are deformed by a pressure such that their pointed ends droop downwards. As a result, the portion of the upper cover 41 where the fragile member 47 was present is opened, and the access path 47A for the supply/exhaust pipe 68 is formed, thus allowing the lower end of the supply/exhaust pipe 68 to penetrate the upper cover 41.

As described above, in breaking the fragile member 47 by pressurizing the supply/exhaust pipe 68, which is a penetrating member, the grooves 48 are provided such that the fragile member 47 is broken along the grooves 48. By fracturing the fragile member 47 along the grooves 48, generation of fine fragments as a result of the breaking of the fragile member 47 is suppressed. Therefore, the grooves 48 contribute to suppressing the fragments from being mixed into the resist in the container nozzle 20.

However, an area outside the recessed portion 46 on a bottom surface of the recessed portion 45 of the upper cover 41 is configured as a flat seal surface 46A to seal the inside of the container nozzle 20 when the fragile member 47 is broken and deformed as described above. This sealing will be described in detail when explaining the transfer unit 6 later. Additionally, an annular protrusion 49 surrounding the recessed portion 46 is formed at a peripheral portion of a bottom surface of the upper wall 43 when viewed from the top. This annular protrusion 49 regulates a position of a side peripheral portion 54 of the inner cover 51, which will be described in detail later.

When a worker twists the upper cover 41 around the axis of the container 2 with respect to the container main body 21, the screw engagement between the upper cover 41 and the container main body 21 may be released. Thus, as described above, the upper cover 41 is detachable from the container main body 21. Further, the protrusion 28 provided at the container main body 21 may have a length that allows the protrusion 28 to project outwards from the groove 35 of the lower cover 31. The protrusion 28 at this time also serves to suppress the worker's hand from slipping on the outer peripheral surface of the container main body 21 when the worker attaches or detaches the upper cover 41 and the container main body 21. That is, when the worker twists the upper cover 41 by holding the side of the container main body 21 with one hand while holding the side of the upper cover 41 with the other hand, the protrusion 28 is caught by the worker's fingers so that the worker's hand is kept from being rotated with respect to the container main body 21. Therefore, the upper cover 41 can be easily attached and detached.

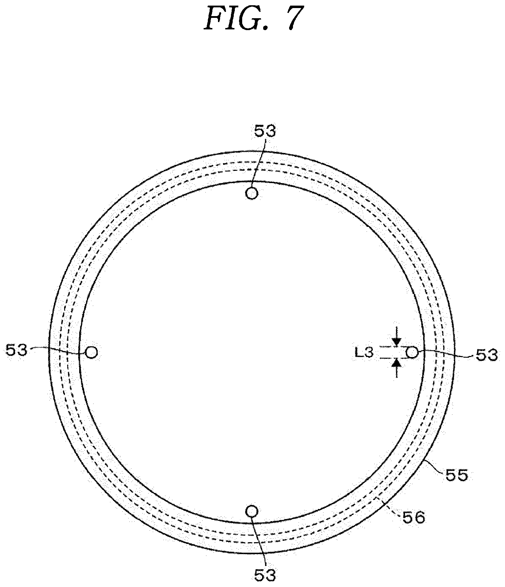

Now, the inner cover 51 will be described with reference to a plan view of FIG. 7 in addition to **FIG.** 3 to **FIG.** 5. This inner cover 51 is configured to close a top opening of the container main body 21, serving as a partition member that partitions the inside of the cylindrical member 22 of the container main body 21 into an upper space and a lower space. The lower space is the storage space 59 for the resist. Accordingly, the top opening of the container main body 21 is closed by this inner cover 51 and is also covered with the above-described upper cover 41, so the above-described fragile member 47 faces the upper space.

The inner cover 51 is integrally molded with resin, specifically, thermoplastic resin, for example. Desirably, polyolefin, and, more preferably, polyethylene or polypropylene may be used as a more specific example of the thermoplastic resin, the same as in the case of the above-described container main body 21. In addition, the inner cover 51 may be made of rubber. Since the inner cover 51 is made of such a material, even if the processing liquid (resist in this example) stored in the storage space 59 comes into contact with the inner cover 51, there is a low risk of metal contamination of the processing liquid. Further, since the inner cover 51 is made of the resins or the rubber mentioned above, it has elasticity.

The inner cover 51 is configured as a rotationally symmetrical body, and has a main body 52 which is plate-shaped body having a circular shape when viewed from the top and formed to extend within the container main body 21 in a transversal direction. The resist is stored in the storage space 59 such that its liquid level is at a height where it does not in contact with the main body 52. For example, 10 mL to 200 mL of the resist is stored. In addition, the lower end of the supply/exhaust pipe 68 put into the container main body 21 as described above is located above a center portion of the main body 52.

The main body 52 is formed to have a bow-shaped longitudinal cross section as a central portion of the main body 52 protrudes higher than a peripheral portion thereof. Therefore, the main body 52 is configured as a curved member, and an area on a top surface of the main body 52 facing the fragile member 47 is located higher than the surrounding area. Further, the top surface of the main body 52 is a second surface formed to face the bottom surface (first surface) of the upper wall 43 provided with the fragile member 47 in the upper cover 41. Accordingly, a central region of the second surface facing the fragile member 47 is protuberated so as to be located closer to the fragile member 47 than the surrounding region.

One or more through holes 53 are formed at a peripheral portion of the main body 52 in a thickness direction of the main body 52. In order to pressurize and decompress the storage space 59 with high uniformity in the circumferential direction, a plurality of, for example, two to eight through holes 53 are provided, and are arranged at an equal distance from the center of the main body 52 and at an equal interval therebetween in a circumferential direction of the main body 52. In the present exemplary embodiment, four through holes 53 are illustrated as being arranged in such a layout. The through hole 53 has a hole diameter L3 of, *e.g.,* 0.5 mm to 3 mm. So as not to compromise the role of the inner cover 51, that is, suppressing the contamination of the resist through the supply/exhaust pipe 68, which will be described in detail later, the through hole 53 is provided at a location not overlapping the fragile member 47 when viewed from the top, that is, a location not overlapping the access path of the supply/exhaust pipe 68 that is formed when the fragile member 47 is broken.

Then, a peripheral edge of the main body 52 is extended upwards to form a cylindrical side peripheral portion 54 with a low height. This side peripheral portion 54 is formed to have an arc-shaped longitudinal cross section such that it is gradually distanced away from the central axis of the inner cover 51 as it goes upwards. Thus, this side peripheral portion 54 is also formed as a curved portion. An upper portion of an outer peripheral surface of this side peripheral portion 54 forms a contact portion in contact with the inner peripheral surface of the container main body 21. An upper end portion of this side peripheral portion 54 is horizontally expanded outwards to form a flange portion 55. A lower portion of this flange portion 55 protrudes to form an annular protrusion 56 along the circumferential direction of the inner cover 51.

The flange portion 55 is interposed between the bottom surface of the upper wall 43 of the upper cover 41 and the upper end of the cylindrical member 22 of the container main body 21, and the annular protrusion 56 is in contact with the upper end of the cylindrical member 22. This annular protrusion 56 is configured to bring a peripheral portion of the inner cover 51 into secure contact with the upper end of the container main body 21 and to improve the airtightness of the storage space 59. Further, an upper portion of the side peripheral portion 54 of the inner cover 51 is interposed between the inner peripheral surface of the container main body 21 and the outer peripheral surface of the annular protrusion 49 of the upper cover 41 and are in contact with them. In this way, as the flange portion 55 is pinched from above and below, and the side peripheral portion 54 is pinched from the inside and the outside thereof, the position of the inner cover 51 is fixed within the container nozzle 20.

In order to explain the effect of the inner cover 51, it is assumed that the inner cover 51 is not provided. In this case, it may be assumed that the resist splashes from the liquid surface of the storage space 59 and adheres to the inside of the supply/exhaust pipe 68 due to vibrations generated during the transfer of the container nozzle 20 or during the supply/exhaust of the gas through the supply/exhaust pipe 68. Since the different types of resist are stored in the containers 2 as described above and the supply/exhaust pipe 68 is shared by the containers 2, the resist attached from one container 2 may be mixed into the resist in another container 2. As described above, however, by providing the inner cover 51 with the through hole 53 at the position apart from the fragile member 47 when viewed from the top, the pressure of the storage space 59 can be varied by the supply and the exhaust of the gas while suppressing the adhesion of the resist to the supply/exhaust pipe 68.

In addition, since the side peripheral portion 54 constituting the inner cover 51 has the curved portion and is elastic, the outer peripheral surface of the side peripheral portion 54 constituting the inner cover 51 is in firm contact with the inner peripheral surface of the container main body 21 while pressurizing the inner peripheral surface. For this reason, when performing the supply and exhaust of the gas through the above-described supply/exhaust pipe 68, leakage of the gas to the outside of the container nozzle 20 through a gap between the inner covers 51 and the container main body 21, or introduction of the gas into the container nozzle 20 from the outside thereof is suppressed. That is, the inner cover 51 is configured to provide high sealing performance for the inside of the container nozzle 20.

In addition, as described above, the top surface of the main body 52 of the inner cover 51 is curved such that its portion facing the fragile member 47 is located higher than the surrounding portion. Therefore, when the gas is supplied downwards from the supply/exhaust pipe 68 advanced into the container nozzle 20 through the fragile member 47, this top surface allows the gas to be uniformly distributed from a discharged position to the vicinity thereof. The gas heading toward the peripheral portion of the main body 52 after being distributed as described above is introduced into the respective through holes 53 at a highly uniform flow rate because the inner cover 51 is rotationally symmetrical. Therefore, a pressure deviation is unlikely to increase in the circumferential direction of the storage space 59. For this reason, in the storage space 59, irregular flow of the resist and foaming due to the splashing of the resist are suppressed. Accordingly, supply of bubbles to the wafer W is suppressed, so that a decrease in the yield of semiconductor products manufactured from the wafer W may be suppressed.

Moreover, in addition to the function of suppressing the contamination of the resist through the above-described supply/exhaust pipe 68, the inner cover 51 also has a function of suppressing, even if fine fragments are generated when the fragile member 47 is broken, the fragments from being mixed into the resist. To elaborate, even if the fragments are generated and fall inside the container nozzle 20, they are received by the inner cover 51 and suppressed from falling into the storage space 59. Further, since the fragments are removed from the inside of the container nozzle 20 by the evacuation through the supply/exhaust pipe 68, the fragments are suppressed from being mixing into the resist.

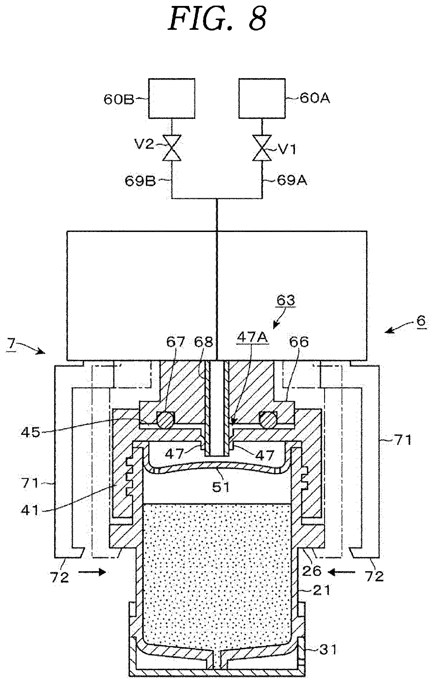

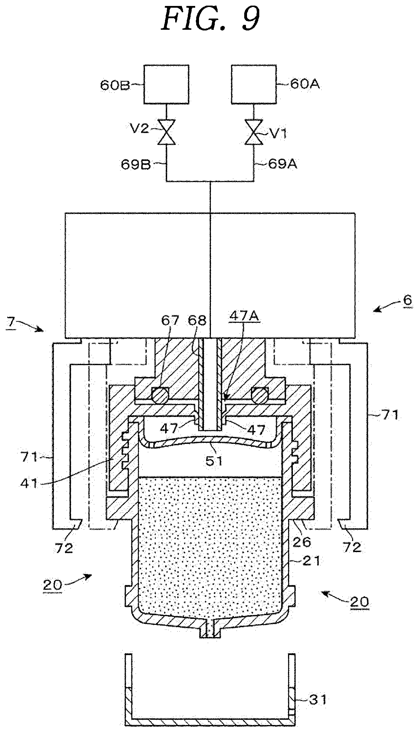

Now, referring back to **FIG. 1** to **FIG. 3****,** the transfer unit 6 will be explained. Reference will also be made appropriately to longitudinal side views of **FIG. 8** and **FIG 9****.** The transfer unit 6 is composed of a mover 61, an arm 62, a supply/exhaust unit 63, and a gripper unit 7. The mover 61 is capable of moving to the left and right in an area on the base 19 in front of the cup 11 (the area on the opposite side to where the wafer W is carried in and out). Further, the mover 61 supports a base end of the arm 62 and vertically moves the arm 62 up and down. A leading end of the arm 62 extends rearwards, and the supply/exhaust unit 63 and the gripper unit 7 are provided at this leading end. The supply/exhaust unit 63 includes a container connector 66, an O-ring 67, the supply/exhaust pipe 68, branch paths 69A and 69B, valves V1 and V2, a gas source 60A and an exhaust source 60B.

The container connector 66 is a circular member that protrudes downwards from the leading end of the arm 62. The lower end of this container connector 66 is formed to have a size enabling it to be fitted into and retracted from the recessed portion 45 of the upper cover 41 of the container 2. On a bottom surface of the container connector 66, an annular groove is provided along the circumference of the container connector 66, and the O-ring 67 is embedded in this annular groove. Further, the aforementioned supply/exhaust pipe 68 is configured to penetrate the center of the container connector 66 in a vertical direction, and the leading end of the supply/exhaust pipe 68 protrudes from the bottom surface of the container connector 66. Therefore, the O-ring 67 is located above the lower end of the supply/exhaust pipe 68, surrounding the supply/exhaust pipe 68 when viewed from the top.

Due to such a positional relationship, when the supply/exhaust pipe 68 is advanced into the container nozzle 20 through the access path 47A formed from the fragile member 47, the container connector 66 is fitted into the recessed portion 45, and the O-ring 67 comes into firm contact with the seal surface 46A of the upper cover 41. Hereinafter, the position of the container nozzle 20 with respect to the transfer unit 6 in this state will be referred to as a mounting position. By being in firm contact with the seal surface 46A as described above, the O-ring has a function of keeping the storage space 59 in the container nozzle 20 sealed against the outside even if the fragile member 47 is broken. The supply/exhaust pipe 68 is made of, for example, stainless steel SUS304 of JIS standard, and has an outer diameter of 3 mm and an inner diameter of 1 mm. Further, an outer surface of the supply/exhaust pipe 68 is mirror-finished, and a lower end surface thereof, which is a part of the outer surface, is horizontal.

One end of a flow path is connected to an upper side of the supply/exhaust pipe 68, and the other end of this flow path is branched into two branch paths 69A and 69B. The branch path 69A is connected to the gas source 60A via the valve V1, and the branch path 69B is connected via the valve V2 to the exhaust source 60B that is configured by, for example, an ejector. As for the valves V1 and V2, both of them are closed, or either one of them is opened. By opening the valve V1, a nitrogen gas as an inert gas, for example, is supplied from the leading end of the supply/exhaust pipe 68, and by opening the valve V2, evacuation from the leading end of the supply/exhaust pipe 68 is performed.

The gripper unit 7 is composed of three claw members 71 and a non-illustrated driving mechanism provided at a leading end of the arm 62. These claw members 71 are disposed at positions 120° apart from each other around the supply/exhaust pipe 68 when viewed from the top, equi-spaced from the supply/exhaust pipe 68, and arranged to be rotationally symmetrical to each other. In addition, in **FIG. 8** and **FIG. 9****,** for convenience of illustration, cross sections of directions different from each other by 120° with respect to the supply/exhaust pipe 68 are shown on the same plane. Thus, the two claw members 71 are shown to be symmetrical with the supply/exhaust pipe 68 sandwiched therebetween.

The claw member 71is vertically elongated, and is formed in an inverted L-shape when viewed from the side. In detail, the claw member 71is horizontally extended away from the supply/exhaust pipe 68 and is then bent downwards. A lower end of the claw member 71slightly protrudes toward the supply/exhaust pipe 68 when viewed from the top, forming a support portion 72. This support portion 72 supports the handle 26 of the container main body 21 from below when the claw member 71grips the handle 26. An upper end of each claw member 71is connected to the aforementioned driving mechanism, and the driving mechanism horizontally moves each claw member 71between an open position (indicated by a solid line in **FIG. 8**) relatively far away from the supply/exhaust pipe 68 and a gripping position (indicated by a dashed line in **FIG. 8**) relatively close to the supply/exhaust pipe 68 when viewed from the top.

Hereinafter, the fragile member 47 of the container 2 will be further explained with reference to **FIG. 5** and **FIG. 6****.** As described above, the fragile member 47 is broken when the supply/exhaust pipe 68 descends. If the breaking strength (the ultimate strength at which the breaking occurs) of this fragile member 47 is too low, handling of the container 2 may become difficult. On the other hand, if the breaking strength is too high, a load on the individual members constituting the apparatus such as the supply/exhaust pipe 68, the arm 62, and the mover 61 may increase, and the fine fragments may be easily generated when the fragile member 47 is broken. Furthermore, if a breaking displacement (deformation amount when the breaking occurs) of the fragile member 47 is too large, there is a likelihood that an increase in the internal pressure of the container main body 21 will become relatively large, raising a risk that the liquid may leak from the discharge port 25. Therefore, the breaking strength of the fragile member 47 is desirably set to, for example, 5 N to 40 N, and the breaking displacement is desirably set to, for example, 4 mm or less. That is, it is desirable that a leading end of the fan-shaped small piece (i.e., a waist-side edge of the fan-shape) caused by the breaking of the fragile member 47 is not moved downwards by more than 4 mm from its original position before the breaking occurs.

In the present exemplary embodiment, the above-described supply/exhaust pipe 68 is configured to descend toward the fragile member 47 at a speed of, for example, 50 mm/min and to apply the breaking strength within the above-described desirable range to the fragile member 47 so that the fragile member 47 undergoes the desirable breaking displacement. Additionally, even if the supply/exhaust pipe 68 is lowered toward the fragile member 47 at a speed of 500 mm/min, the breaking strength is 23 N and the breaking displacement is 3 mm, which respectively fall within the aforementioned desirable ranges. Therefore, when lowering the supply/exhaust pipe 68 to break the fragile member 47, it is desirable to set the speed to be in the range of 50 mm/min to 500 mm/min.

In order to achieve such desirable braking strength and breaking displacement for the fragile member 47, it is desirable to provide two to six grooves 48 as stated above. Further, in order to achieve the desirable breaking strength and breaking displacement, it is desirable to set a thickness H1 of a region (a region outside the grooves 48) of the fragile member 47 other than the grooves 48 to, *e.g.,* 0.2 mm to 1 mm; a thickness H2 of each groove 48 to, *e.g.,* 0.1 mm to 0.95 mm; and a width L4 of the groove 48 to, *e.g.,* 0.2 mm to 3 mm. Further, a ratio of the thickness H2 of the groove 48 to the thickness H1 of the fragile member 47 is desirably set to be in the range of, *e.g.,* 10% to 95%, and a diameter L5 of the fragile member 47 is desirably set to, *e.g.,* 5 mm to 30 mm.

Hereinafter, a processing sequence for the wafer W by the resist coating apparatus 1 will be described. It is assumed that the arm 62 is not holding the container nozzle 20, the supply/exhaust of the gas from the supply/exhaust pipe 68 in the arm 62 is stopped, and the claw members 71 of the arm 62 are located at the open position. The wafer W is transferred to the resist coating apparatus 1 by a non-illustrated transfer mechanism, and is attracted to and held by the spin chuck 12.

The arm 62 constituting the transfer unit 6 moves in the left-and-right direction, and the supply/exhaust pipe 68 constituting the transfer unit 6 is placed above the fragile member 47 of the container 2, in which the resist set to process the wafer W is stored, in the container placement unit 8. When the evacuation from the supply/exhaust pipe 68 is begun, the arm 62 descends, and the O-ring 67 comes into firm contact with the seal surface 46A of the upper cover 41 as described above. Meanwhile, the lower end of the supply/exhaust pipe 68 presses the fragile member 47, and the fragile member 47 is broken and deformed as described above, forming the access path 47A. The leading end of the supply/exhaust pipe 68 is advanced into the container nozzle 20 through this access path 47A, and the container nozzle 20 is located at the mounting position of the transfer unit 6. Afterwards, the claw members 71 are moved to the gripping position, and the side surface of each claw member 71presses the side surface of the handle 26 of the container nozzle 20 toward the central axis of the container nozzle 20. As a result, the container nozzle 20 is pressurized and gripped by the transfer unit 6. **FIG. 8** shows the container nozzle 20 and the transfer unit 6 when the gripping is performed in this way.

Thereafter, the arm 62 is raised, and the handle 26 of the container nozzle 20 is pulled up by the support portions 72 of the claw members 71. As a result, the engagement between the lower cover 31 and the container nozzle 20 is released, so that the lower cover 31 is separated from the container nozzle 20. At this time, since the storage space 59 is decompressed by the evacuation through the supply/exhaust pipe 68, the resist is suppressed from flowing down from the discharge port 25 of the container nozzle 20 even when the lower cover 31 is separated. **FIG. 9** shows the container nozzle 20 and the transfer unit 6 when the lower cover 31 is separated in this way.

When the container nozzle 20 held by the transfer unit 6 is located above the center portion of the wafer W, the evacuation is stopped; the gas supply is started from the supply/exhaust pipe 68 to pressurize the container nozzle 20; and the resist is supplied from the discharge port 25 to the center portion of the wafer W. Then, the gas supply from the supply/exhaust pipe 68 is stopped and the evacuation is started again to decompress the container nozzle 20, and the discharge of the resist from the discharge port 25 is stopped. As the wafer W is rotated, the resist supplied to the wafer W is diffused onto the entire surface of the wafer W, forming the resist film. Thereafter, the wafer W is carried out from the resist coating apparatus 1 by the transfer mechanism.

For example, after the film forming process as described above is performed on the wafers W sequentially transferred to the apparatus, the transfer unit 6 performs operations opposite to the operations performed when the container nozzle 20 is mounted. Specifically, the mounting of the lower cover 31 to the container nozzle 20 by the descent of the transfer unit 6 into the container placement unit 8 (that is, the engagement between the lower cover 31 and the container nozzle 20), the movement of the claw members 71 to the open position, and the opening of the container nozzle 20 from the mounting position by the ascent of the transfer unit 6 are performed sequentially.

In applying the resist to the wafer W, it may be considered to adopt an apparatus configuration in which a nozzle and a resist source (tank) are connected by a pipeline and the resist is discharged from the nozzle by a pump provided in the pipeline, as described in Patent Document 1. If, however, a processing is performed by using multiple types of resist in such an apparatus configuration, the tank needs to be replaced with the one storing therein the required resist when switching the resist to be used, resulting in an inconvenience of connecting the pipeline to the corresponding tank. In addition, when replacing the tank in this way, it is required to perform various works such as cleaning the pipeline with a cleaning liquid, removing the cleaning liquid from the pipeline, filling the pipeline with resist, and so forth to suppress the resist supplied to the wafer W from being contaminated by another resist or from being mixed with air bubbles. Therefore, preparation for the processing (works accompanying processing) may become very troublesome.

In addition to replacing the tank, it may be considered to provide a plurality of nozzles, tanks, and pipeline systems connecting the nozzles and the tanks and equipped with valves and pumps and to supply various types of resist to the wafer W by switching the pipeline systems to be used. Since, however, the pipeline system requires a relatively large space, the number of the pipeline systems that can be provided in the apparatus is limited. For this reason, the types of the resist that can be used in the apparatus are limited based on the number of the pipeline systems, which raises a concern that sufficient types of resist may not be used. In addition, it is assumed that a worker supplies the resist to the wafer W manually. That is, it is assumed that the worker supplies the resist by tiling a bottle containing the required resist on the wafer W each time the processing is performed. In such a case, however, the worker needs to be on standby near the apparatus when processing a multiple number of wafers W continually, which imposes great burden and trouble on the worker.

However, as described above, the container nozzle 20 constituting the container 2 is equipped with the discharge port 25, the storage space 59 for the resist, and the fragile member 47. The supply/exhaust pipe 68 included in the transfer unit 6 configured to transfer the container nozzle 20 is advanced into the container nozzle 20 through the access path 47A that is formed as the fragile member 47 is broken and deformed, and the pressurization and the decompression of the storage space 59 within the container nozzle 20 can be switched. Therefore, in the container nozzle 20, the resist can be discharged from the discharge port 25 only when necessary, and the leakage of the resist from the discharge port 25 is suppressed in other cases. Therefore, in the resist coating apparatus 1 equipped with such containers 2, resist coating can be performed by selecting one of the containers 2 and transferring the container nozzle 20 constituting the selected container 2 to above the wafer W. Therefore, as compared to the case where the worker performs the work manually, the burden on the worker is reduced, and the troublesome works, such as the above-described cleaning of the pipeline, involved in the processing can be reduced. Additionally, the apparatus may have a configuration in which only one container 2 is provided. In such a case as well, since the work such as the cleaning of the pipeline is unnecessary, the works involved in the processing by the apparatus may be reduced.

The handle 26 used to grip the container nozzle 20 is provided on the container main body 21 between the container main body 21 and the upper cover 41 that constitute the outer surface of the container nozzle 20. For example, if it is assumed that the handle 26 is provided on the upper cover 41, the screw engagement between the upper cover 41 and the container main body 21 may be released due to such a factor as vibration during the transfer so that the container main body 21 may fall down, or the height of the container main body 21 may be deviated with respect to the upper cover 41, having an adverse influence on the processing. However, by providing the handle 26 on the container main body 21, such problems are suppressed. Further, the handle 26 is designed to be non-detachable from the cylindrical member 22 forming the body of the container main body 21. Therefore, it is possible to suppress the handle 26 from falling off and the cylindrical member 22 from falling down during the transfer due to the aforementioned vibration or the like.

In addition, as described above, since the container 2 has the configuration in which the upper cover 41 and the inner cover 51 are detachable from the container main body 21, the resist can be easily filled from above the container main body 21, which is regarded as an advantage. The fragile member 47 is provided in the upper cover 41 between the container main body 21 and the upper cover 41 that constitute the outer surface of the container nozzle 20. Thus, when filling the container main body 21 with the resist, there is no need for the worker to handle the upper cover 41, so accidental breakage of the fragile member 47 is suppressed.

Moreover, although the container 2 may be discarded after being used, it may also be possible to reuse it by refilling it with the resist. Even in such a case of reusing the container 2, it is still advantageous to provide the fragile member 47 in the upper cover 41 between the container main body 21 and the upper cover 41. In reusing the container 2, the worker may perform operations such as separating the upper cover 41 from the container main body 21, discarding the resist remaining in the container main body 21, cleaning the container main body 21, and refilling the resist. When performing these individual operations, since there is no need for the worker to handle the upper cover 41, the accidental breakage of the fragile member 47 is suppressed. In addition, since the fragile member 47 is not provided in the container main body 21, the container main body 21 is easy to handle, so it is easy to perform the above-described operations for reusing the container 2. Moreover, the configuration that the upper cover 41 is detachable from the container main body 21 also contributes to facilitating the configuration of the above-described operations for reusing the container 2.

Furthermore, the handle 26 is provided at the container nozzle 20 along the circumferential direction thereof, the upper cover 41 is provided above the handle 26, and the top surface of this upper cover 41 is configured as the seal surface 46A that comes into firm contact with the O-ring 67 of the transfer unit 6 to seal the inside of the container nozzle 20. For this reason, when the handle 26 is gripped by the claw members 71 and the support portions 72 constituting the claw members 71 support the handle 26 from below, the upper cover 41 is pressed relatively toward the container main body 21 by the O-ring 67, which is the elastic material. Accordingly, the upper cover 41 is less likely to be loosened with respect to the container main body 21, so high sealing performance for the inside of the container nozzle 20 is obtained during the transfer. In addition, this seal surface 46A is formed on the upper wall 43 of the upper cover 41, that is, at a position overlapping the container main body 21 from above the container main body 21. Accordingly, the upper cover 41 configured to have the seal surface 46A is suppressed from being enlarged in size with respect to the container main body 21, and, therefore, scale-up of the container 2 is suppressed.

In order to bring the lower cover 31 into firm contact with the container nozzle 20, there may be adopted a configuration in which a protrusion or a recess is provided inside the lower cover 31, and the protrusion or the recess is engaged with a portion of the container nozzle 20 provided to correspond to the protrusion or the recess. Further, a cushioning material may be provided at the lower cover 31 to bring it into firm contact with the container nozzle 20. In addition, the lower cover 31 not only serves to block the discharge port 25 of the container nozzle 20 but also serves as a support to suppress the tilting of the container nozzle 20. However, there may be adopted a configuration in which the container nozzle 20 is directly supported and the discharge port 25 is blocked by the recessed portion 81 provided in the container placement unit 8. Therefore, in such a configuration, the lower cover 31 may not be provided in the container 2. Furthermore, the leading end portion 24 of the container nozzle 2 forming the discharge port 25 may be of a straight shape, that is, a vertically extending cylindrical shape, may be rounded, may have a shape that narrows toward the end, may have a shape like an injection needle, or may have a tapered cut shape so as to come into contact with the lower cover 31. To describe the protrusion or the recess of the lower cover 31 in detail, the lower cover 31 may be provided with the recess into which the leading end portion 24 formed as described above is fitted, or may be provided with the protrusion to be fitted into the discharge port 25.

The fragile member provided in the upper cover 41 is not limited to being formed integrally with the above-described upper cover 41. For example, a thin film closing the through hole formed in the upper wall 43 of the upper cover 41 and formed as a separate body from the upper cover 41 may be provided as the fragile member. In such a case, the thin film may be broken by being pressed by the supply/exhaust pipe 68, allowing the supply/exhaust pipe 68 to be advanced into the container nozzle 20 through the upper cover 41. In order to achieve the breaking strength in the above-specified range, the thickness of this thin film may be set to be in the range of, *e.g.,* 0.03 mm to 1 mm.

Further, the inner cover 51 is provided within the container 2 as described above to suppress the adhesion of the resist to the supply/exhaust pipe 68 due to the pressure change in the container 2 or the vibration during the transfer as described above. However, this contamination can be suppressed by controlling the gas supply amount/exhaust amount or by suppressing the vibration with the adjustment of the speed in the transfer. Therefore, there may be adopted a configuration in which the container 2 does not have the inner cover 51. Furthermore, the handle 26 of the container nozzle 2 may have any configuration as long as it is capable of gripping the container nozzle 20, and its shape is not limited to the annular shape. For example, the handle 26 may be implemented by protrusions formed while being spaced apart from each other in the circumferential direction of the outer peripheral surface of the container main body 21. Even in such a case, the container nozzle 20 can be held such that the upper cover 41 is pressed relatively toward the container main body 21 by using the O-ring 67 as described.

In addition, the container 2 is not limited to storing the resist therein. For example, various processing liquids such as a coating liquid for forming an anti-reflection film, a coating liquid for forming an insulating film, a developer, a cleaning liquid for the wafer W, and an adhesive for bonding the wafers W may be stored in the container 2 to perform various processings. Regarding a method of molding the container 2, although any of various commonly known molding methods may be adopted, it is desirable to form the container 2 by injection molding. Further, graduation marks indicating the content of the processing liquid such as the resist may be provided on inner and outer surfaces of the container 2, and steps may be provided as the graduation marks.

The exemplary embodiments disclosed herein are illustrative in all aspects and do not limit the present disclosure. The above-described exemplary embodiments may be omitted, replaced and modified in various ways without departing from the scope and the spirit of the appended claims.

### EXPLANATION OF CODES

W: Wafer
2: Container
20: Container nozzle
25: Discharge port
47: Fragile portion
47A: Access path
59: Storage space
68: Supply/exhaust pipe

## Claims

1. A container, comprising:
a storage space forming unit in which a storage space storing therein a processing liquid configured to process a substrate is formed;
a discharge port of the processing liquid, provided in the storage space forming unit; and
a fragile member provided in the storage space forming unit and configured to be broken by being pressurized with a penetrating member in order to form an access path, the penetrating member being configured to pressurize the storage space such that the processing liquid is discharged from the discharge port, and the penetrating member being advanced into the storage space forming unit through the access path.

2. The container of Claim 1,
wherein the discharge port is opened downwards, and
the container further comprises a lower cover allowed to be attached to and detached from the storage space forming unit, and configured to close the discharge port from below when attached to the storage space forming unit.

3. The container of Claim 2,
wherein the storage space forming unit has an engaging member, and
the lower cover has an engaged member to be engaged with the engaging member.

4. The container of Claim 1,
wherein the storage space forming unit comprises a container main body provided with the discharge port, and an upper cover allowed to be attached to and detached from the container main body, and
the upper cover has a seal surface configured to seal an inside of the storage space forming unit, in which the access path is formed, by being brought into firm contact with a transfer unit, the transfer unit having the penetrating member and being configured to transfer the storage space forming unit.

5. The container of Claim 4,
wherein the fragile member is provided in the upper cover.

6. The container of Claim 4,
wherein, on a side surface of the container main body below the upper cover, a protrusion which protrudes toward an outside of the container main body and which is integrally molded with the side surface is formed along a circumferential direction of the container main body so as to be gripped by the transfer unit.

7. The container of Claim 1,
wherein a recess is locally provided in the fragile member, and a bottom portion of the recess is formed as a thin wall member whose thickness is smaller than that of a portion outside the recess.

8. The container of Claim 1,
wherein the fragile member has a breaking strength ranging from 5 N to 40 N, and a breaking displacement of 4 mm or less.

9. The container of Claim 1, further comprising:
an inner cover configured to partition a space surrounded by the storage space forming unit into an upper space facing the fragile member and a lower space forming the storage space,
wherein a through hole is formed at a portion of the inner cover not overlapping the fragile member when viewed in a plan view, the through hole allowing the upper space and the lower space to communicate with each other.

10. The container of Claim 9,
wherein an outer peripheral surface of the inner cover has a contact portion in contact with an inner peripheral surface of the storage space forming unit.

11. The container of Claim 9,
wherein the upper cover has a first surface including the fragile member, and the inner cover has a second surface facing the first surface including, and
a region of the second surface facing the fragile member is protuberated so as to be located closer to the first surface than a surrounding area.
